# EUROPÄISCHE PATENTSCHRIFT

(11) **EP 0 731 526 B1**
(45) Veröffentlichungstag und Bekanntmachung des Hinweises auf die Patenterteilung: **07.07.1999**
(21) Anmeldenummer: 96102453.6
(22) Anmeldetag: 19.02.1996
(51) Int. Cl.: H01R 9/09

(54) **Stiftförmiges Kontaktelement**
Pin-shaped contact element
Elément de contact en forme de fiche

(30) Priorität: 08.03.1995 DE 19508133
(43) Veröffentlichungstag der Anmeldung: 11.09.1996
(73) Patentinhaber: Leopold Kostal GmbH & Co. KG, 58507 Lüdenscheid (DE)
(72) Erfinder: Sorig, Ludger, D-59387 Ascheberg (DE)

(56) Entgegenhaltungen:
- DE-A- 4 422 876
- US-A- 4 513 499
- US-A- 4 795 378
- US-A- 4 897 053

## Beschreibung

Die vorliegende Erfindung geht von einem entsprechend dem Oberbegriff des Hauptanspruches konzipierten stiftförmigen Kontaktelement zur kontaktgebenden Befestigung in metallisierten Lochungen von elektrischen Leiterplatten aus.

Solche stiftförmigen Kontaktelemente sind insbesondere dafür vorgesehen, durch Einpressen in metallisierte Lochungen von elektrischen Leiterplatten eine elektrisch leitende Verbindung zu zumindest einer Leiterbahn der elektrischen Leiterplatte herzustellen. Über den zum Beispiel als Kontaktstift oder als Kontaktbuchse ausgebildeten Anschlußbereich des Kontaktelementes können zum Beispiel elektrische/elektronische Geräte oder Steckverbindungen mit der Leiterbahn bzw. den Leiterbahnen in Verbindung gebracht werden. Zur einwandfreien Kontaktierung der metallisierten Lochungen müssen deren Fertigungstoleranzen durch entsprechende Ausbildungen des Einpreßbereiches des Kontaktelementes ausgeglichen werden, damit eine gasdichte Verbindung zwischen der Lochung und dem Einpreßbereich gewährleistet ist. Aus diesem Grunde sind die Einpreßbereiche solcher Kontaktelemente oftmals gegen entsprechende Kraft flexibel verformbar ausgebildet. Dies wird zum Beispiel durch ein in den Einpreßbereich eingestanztes, nadelöhrartig ausgebildetes Langloch erreicht, weil dadurch zwei federelastisch aufeinanderzu bewegbare Kontaktschenkel gebildet sind. Durch die federelastische Ausbildung der Kontaktschenkel ist gewährleistet, daß übliche Fertigungstoleranzen überbrückt werden können und somit genügend Kontaktkraft für eine gasdichte elektrische Verbindung zur Verfügung steht.

Ein dem Oberbegriff des Hauptanspruches entsprechendes stiftförmiges Kontaktelement ist durch das DE 90 02 174 U1 bekanntgeworden. Der Einpreßbereich dieses Kontaktelementes umfaßt zwei nebeneinanderliegend verlaufend angeordnete Kontaktschenkel, die durch ein nadelöhrartig ausgebildetes Langloch voneinander beabstandet sind. Die federelastisch aufeinander zubewegbaren Kontaktschenkel kommen mit ihrer äußeren Längsseite unter Erzeugung von Lochleibungskräften an der Wandung der Lochung einer elektrischen Leiterplatte kontaktgebend zur Anlage. Die Kantenbereiche der Längsseiten der beiden Kontaktschenkel weisen eine deutlich abgerundete Form auf. Ausgehend von einer Einführzone, in welche die beiden Kontaktschenkel V-förmig unter einem spitzen Winkel zueinander verlaufen, gehen die äußeren Längsseiten der beiden Kontaktschenkel in einen in Steckrichtung verlaufenden, zur Kontaktierung vorgesehenen, einen wesentlichen Teil ausmachenden Bereich über, welche parallel zueinander verlaufend ausgebildet bzw. angeordnet ist.

Außerdem ist durch die DE 36 30 629 A1 ein stiftförmiges Kontaktelement bekanntgeworden, welches ebenfalls eine Einführzone mit V-förmig unter einen spitzen Winkel angeordnete Kontaktschenkel aufweist. Die zur Kontaktierung vorgesehenen, einen wesentlichen Teil ausmachenden Bereiche der beiden Kontaktschenkel sind parallel zueinander verlaufend angeordnet.

Desweiteren ist durch die EP 0 225 400 A1 ein stiftförmiges Kontaktelement bekanntgeworden, welches drei Kontaktschenkel aufweist, wobei in einem der Kontaktschenkel eine in Steckrichtung verlaufende, zur Aufnahme von verdrängtem Material vorgesehene Rinne eingebracht ist. Auch bei diesem Kontaktelement verlaufend die zur Kontaktierung vorgesehenen Bereiche der Kontaktschenkel parallel zueinander.

Eine solche parallel zueinander verlaufende Ausbildung der kontaktgebenden Bereiche der Kontaktschenkel kann bei einem stiftförmigen Kontaktelement, insbesondere bei ungünstigen Toleranzlagen dazu führen, daß die realisierbaren Haltekräfte der Kontaktelemente in Bezug auf die aufzubringenden Einsteckkräfte nur ein relativ niedriges Niveau erreichen. In Bezug auf die gesamte übliche Lebensdauererwartung bei solchen Verbindungen, kann dies dazu führen, daß eine für die Funktionssicherheit notwendige gasdichte Kontaktierung zwischen der Lochung einer Leiterplatte und den eingebrachten Kontaktelementen nicht immer gewährleistet ist.

Der vorliegenden Erfindung liegt deshalb die Aufgabe zugrunde, den Einpreßbereich eines stiftförmigen Kontaktelementes zur kontaktgebenden Befestigung in metallisierten Lochungen von elektrischen Leiterplatten derart weiterzubilden, so daß durch dessen Formgebung Haltekräfte für in die Leiterplatte eingebrachte Kontaktelemente realisiert sind, die in etwa das hohe Niveau der Einpreßkräfte erreichen, so daß selbst bei ungünstigen Toleranzlagen mit großer Zuverlässigkeit gasdichte elektrische Verbindungen mit einer hohen Lebensdauererwartung zwischen der metallisierten Beschichtung der Lochungen und den eingebrachten Kontaktelementen realisiert sind.

Erfindungsgemäß wird die Aufgabe durch die im kennzeichnenden Teil des Hauptanspruches angegebenen Merkmale gelöst. Vorteilhaft bei einer solchen Ausbildung ist, daß durch den vergleichsweise kurz bauenden, federelastisch ausgebildeten Einpreßbereich die üblicherweise bei Lochungen von elektrischen Leiterplatten auftretenden Toleranzen besonders zuverlässig ausgeglichen werden. Darüber hinaus wird durch den relativ kurz bauenden Einpreßbereich eine gute Ausnutzung des in elektrischen/elektronischen Geräten oftmals knappen Bauraumes ermöglicht.

Weitere vorteilhafte Ausgestaltungen des erfindungsgemäßen Gegenstandes sind in den Unteransprüchen angegeben. Anhand eines in den Zeichnungen dargestellten Ausführungsbeispieles wird die Erfindung näher erläutert. Dabei zeigen
- Fig. 1: ein stiftförmiges Kontaktelement in räumlicher Darstellung
- Fig. 2: ein in eine Lochung einer elektrischen Leiterplatte eingepreßtes Kontaktelement gemäß Fig. 1 im Schnitt.
- Fig. 3: ein Kontaktelement im Schnitt entsprechend Fig. 2 gemäß der Linie A-A

Wie aus den Zeichnungen hervorgeht, besteht ein solches stiftförmiges Kontaktelement zur kontaktgebenden Befestigung in metallisierten Lochungen 1 von elektrischen Leiterplatten 2 im wesentlichen aus einem mit einem Langloch 3 versehenen Einpreßbereich 4, an den sich ein Anschlußbereich 5 anschließt.

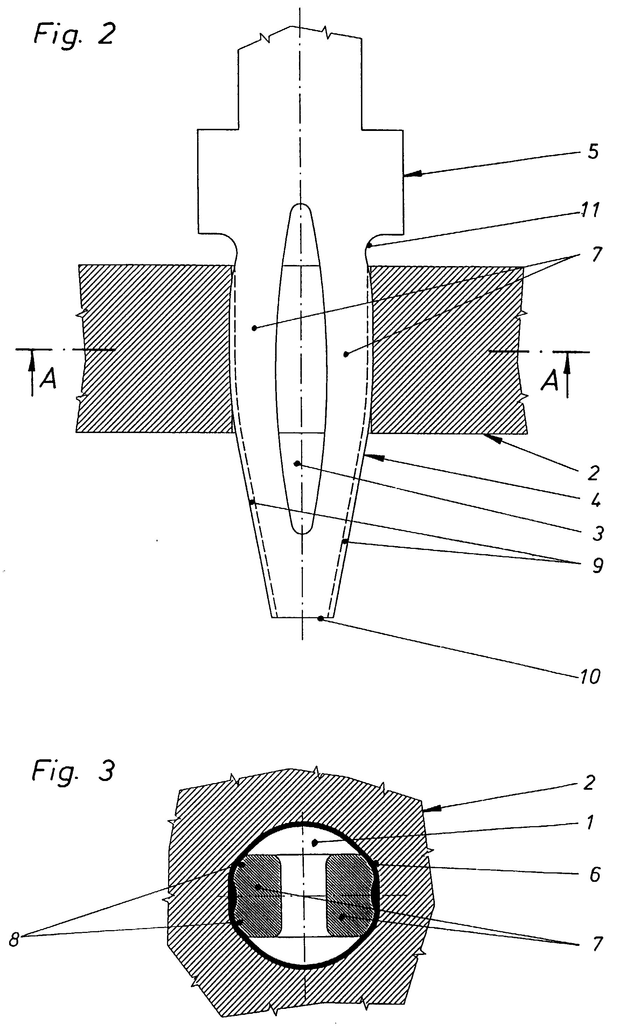

Wie insbesondere aus Fig. 2 und Fig. 3 hervorgeht, ist die Lochung 1 zur elektrisch leitenden Verbindung mit dem Kontaktelement mit einer metallischen Beschichtung 6 versehen. Bei dieser metallischen Beschichtung 6 handelt es sich wegen der guten Kontakt- und Hafteigenschaften sowie des relativ günstigen Preises um Zinn. Damit eine gasdichte elektrische Verbindung zwischen der Zinnbeschichtung der Lochung 1 und der ebenfalls mit einer Zinnbeschichtung versehenen Oberfläche des Einpreßbereiches 4 hergestellt wird, muß über den Einpreßbereich 4 eine bestimmte Lochleibungskraft auf die Wandung der Lochung 1 ausgeübt werden. Die notwendige Lochleibungskraft wird beim Einpreßvorgang durch die beiden sich federelastisch zusammendrückenden Kontaktschenkel 7 des Einpreßbereiches 4 erzeugt.

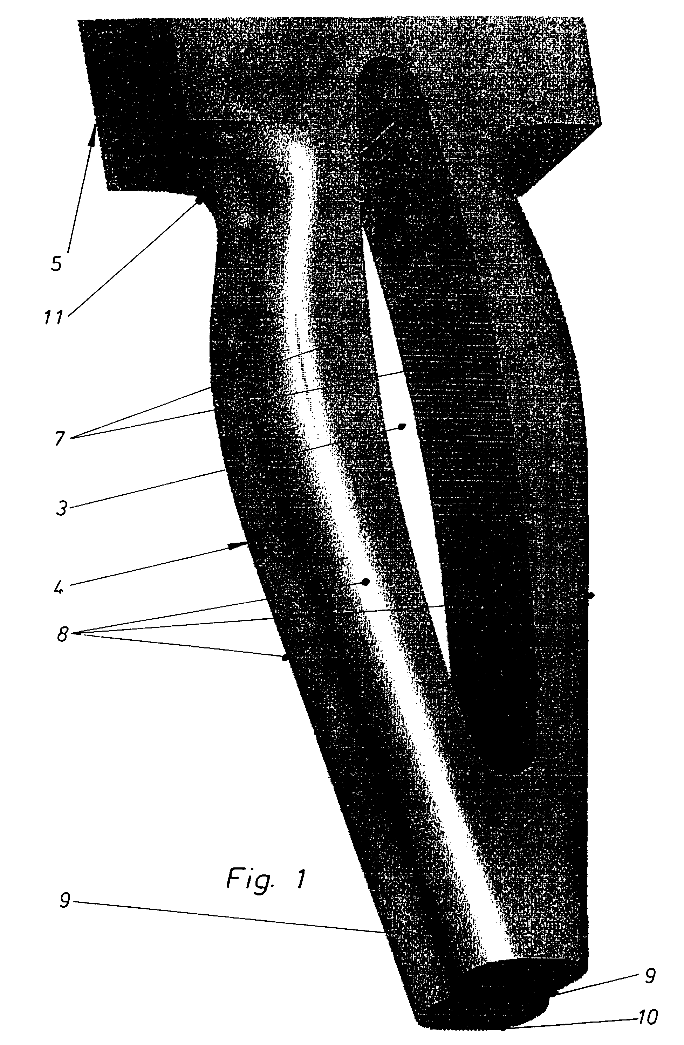

Wie insbesondere aus Fig. 1 hervorgeht, ist im Einpreßbereich 4 ein nadelöhrartig ausgebildetes Langloch 3 vorhanden. Durch einen Stanzvorgang wird das Langloch 3 in den Einpreßbereich 4 eingebracht, wodurch dann die beiden Kontaktschenkel 7 entstehen. Die vier an der Wandung der Lochung 1 zur Anlage kommenden Kantenbereiche 8 der beiden Kontaktschenkel 7 weisen eine deutlich abgerundete Form auf, wobei der Radius der Kantenbereiche 8 etwa dem Radius der Lochung 1 entspricht. Diese abgerundete Form der Kantenbereiche 8 wird durch einen Prägevorgang hergestellt. In die beiden Längsseiten der Kontaktschenkel 7 ist jeweils eine in Längsrichtung verlaufende Rinne 9 eingeformt, die beim Einpressen zur Aufnahme von verdrängten Material vorgesehen ist. Auch die beiden Rinnen 9 werden durch einen Prägevorgang hergestellt. Bei dem verdrängten Material kann es sich dabei sowohl um Zinn der Beschichtung der Lochung 1, als auch um Zinn der Beschichtung des Einpreßbereiches 4 handeln. Die beiden Rinnen 9 erstrecken sich jeweils über die gesamte Länge der Längsseiten der Kontaktschenkel 7 und teilen dabei die Längsseiten in zwei gleichgroße, in Längsrichtung verlaufende Kontaktstege auf. Damit keine scharfkantigen Bereiche entstehen, sind die beiden Rinnen 9 jeweils im Querschnitt kreissegmentförmig ausgebildet und gehen in einem weichen Radius in die beiden sich jeweils anschließenden Kontaktstege der beiden Kontaktschenkel 7 über.

Um auf kurzer Länge eine besonders gute Federelastizität für die beiden Kontaktschenkel 7 zu erreichen, erstreckt sich das nadelöhrartig ausgebildete Langloch 3 ausgehend in geringem Abstand vom freien Ende 10 des Einpreßbereiches 4 bis in die Unterseite des Anschlußbereiches 5 hinein. Dabei macht der Abschnitt vom freien Ende 10 bis zum Anfang des Langloches 3 lediglich ca. 20 % und der in den Anschlußbereich 5 hineinragende Abschnitt des Langloches 3 min. 10 % der Gesamtlänge des Einpreßbereiches 4 aus. Außerdem ist die Kontur des Langloches 3 und der Verlauf der Längsseiten der beiden Kontaktschenkel 7 derart aufeinander abgestimmt, so daß der Querschnitt eines jeden der beiden Kontaktschenkel 7 ausgehend etwa vom Anfang des Langloches 3 bis zum erreichen eines maximalen Querschnittes kontinuierlich zunehmend ausgebildet ist. Ausgehend vom maximalen Querschnitt nimmt dieser eines jeden der beiden Kontaktschenkel 7 wieder kontinuierlich ab, bis eine angrenzende Übergangszone 11 erreicht wird, um in der recht kurz gehaltenen Übergangszone 11 bis zum Erreichen des Anschlußbereiches 5 wieder kontinuierlich zunehmend ausgebildet zu sein. Die beiden Längsseiten der beiden Kontaktschenkel 7 weisen somit im wesentlichen einen bogenförmigen Verlauf auf, wobei die beiden Längsseiten bis zum Erreichen des maximalen Querschnittes V-förmig unter einem spitzen Winkel von unter 35° zueinander verlaufend angeordnet sind.

Beim Einpreßvorgang des Kontaktelementes kommt zunächst, ohne Lochleibungskräfte auszuüben, das freie Ende 10 des Einpreßbereiches 4 in der Lochung 1 der Leiterplatte 2 zu liegen. Wegen der beiden unter einem spitzen Winkel zueinander verlaufend angeordneten Kontaktschenkel 7 erfolgt beim weiteren Einpressen relativ langsam eine kontinuierliche Steigerung der ausgeübten Lochleibungskräfte. Dies geschieht bis bei voller Stecktiefe des Kontaktelementes der mit der größten Ausdehnung aufweisende Bereich des Einpreßbereiches 4 in der Lochung 1 zuliegen kommt. Bei voller Stecktiefe ist die dem Einpreßbereich 4 zugewandte Unterseite des Anschlußbereiches 5 der einen Hauptfläche der elektrischen Leiterplatte 2 zugeordnet, kommt jedoch nicht an dieser zur Anlage. Ein kontinuierlicher langsamer Anstieg der Lochleibungskräfte beim Einpreßvorgang ergibt sich auch wegen der schon näher beschriebenen Form des Langloches 3 sowie der Querschnittsausbildung der beiden Kontaktschenkel 7. Durch die beiden Rinnen 9 kann somit das während des Einpreßvorgangs verdrängte Zinn der Beschichtung der Lochung 1 sowie des Einpreßbereiches 4 gut aufgenommen werden. Durch die vorbeschriebene Formgebung des Einpreßbereiches 4 und der Verwendung von Zinn als Beschichtungsmaterial ergibt sich trotz einer hohen Elastizität der Kontaktschenkel 7 eine hohe Haltekraft der Kontaktelemente in ihren Lochungen 1. Somit ergibt sich im Betrieb eine, gegen ungewolltes Entfernen sichere Halterung der Kontaktelemente in den Lochungen 1 der Leiterplatten 2.

Insgesamt ist somit ein Einpreßbereich 4 entstanden, der auch bei ungünstiger Toleranzlage von Lochung 1 und Einpreßbereich 4 für eine sichere gasdichte Kontaktierung Sorge trägt und bei dem darüber hinaus wirkungsvoll verhindert ist, daß es zur Spanbildung an den metallischen Beschichtungen kommt. Durch seine ausgeprägte Federelastizität ist der Einpreßbereich 4 in der Lage, bei sicherer gasdichter Kontaktierung selbst im Bereich von 10% liegende Unterschiede bei den Lochungsdurchmessern auszugleichen. In der Praxis bedeutet dies, daß stiftförmige Kontaktelemente mit ein und demselben Einpreßbereich 4 in Lochungen 1 mit stark, ggf. definiert unterschiedlichen Durchmessern eingesetzt werden können.

## Patentansprüche

1. Stiftförmiges Kontaktelement zur kontaktgebenden Befestigung in metallisierten Lochungen von elektrischen Leiterplatten, mit einem Anschlußbereich und einem der Lochung zugeordneten Einpreßbereich, wobei der Anschlußbereich mit seiner dem Einpreßbereich zugewandten Unterseite einer der Hauptflächen der elektrischen Leiterplatte zugeordnet wird und wobei im Einpreßbereich ein nadelöhrartig ausgebildetes Langloch vorhanden ist, so daß zwei federelastisch aufeinander zu bewegbare Kontaktschenkel gebildet sind, die an ihrem freien Ende einstückig miteinander in Verbindung stehen, und deren einander abgewandte, äußere Längsseiten unter Erzeugung von Lochleibungskräften an der Wandung der Lochung zur Anlage kommen, wobei die Kantenbereiche der V-förmig unter einem spitzen Winkel zueinander verlaufenden Längsseiten der beiden Kontaktschenkel eine deutlich abgerundete Form aufweisen, **dadurch gekennzeichnet**, daß sich das die beiden Kontaktschenkel (7) bildende Langloch (3) ausgehend im geringen Abstand vom freien Ende (10) des Einpreßbereiches (4) bis in die Unterseite des Anschlußbereiches (5) hineinerstreckt, wobei die Kontur des Langloches (3) und der bogenförmige Verlauf der Längsseiten der beiden Kontaktschenkel (7) derart aufeinander abgestimmt sind, so daß der Querschnitt eines jeden der beiden Kontaktschenkel (7) ausgehend etwa vom Anfang des Langloches (3) bis zum Erreichen des Maximums kontinuierlich zunehmend und ausgehend vom Maximum bis zum Erreichen einer Übergangszone zu der Unterseite des Anschlußbereiches (5) kontinuierlich abnehmend ausgebildet ist.

2. Stiftförmiges Kontaktelement nach Anspruch 1, dadurch gekennzeichnet, daß in jede der beiden Längsseiten der beiden Kontaktschenkel (7) zumindest eine in Längsrichtung verlaufende Rinne (9) eingeformt ist.

3. Stiftförmiges Kontaktelement nach Anspruch 1 oder 2, dadurch gekennzeichnet, daß sich die Rinne (9) zumindest über den mittleren, die größte Ausdehnung der Kontaktschenkel (7) aufweisenden Abschnitt jeder der beiden Längsseiten erstreckt.

4. Stiftförmiges Kontaktelement nach Anspruch 1 oder 2, dadurch gekennzeichnet, daß sich die Rinne (9) über die gesamte Länge jeder der beiden Längsseiten erstreckt.

5. Stiftförmiges Kontaktelement nach einem der Ansprüche 1 bis 4, dadurch gekennzeichnet, daß die Rinne (9) jede der beiden Längsseiten in zwei gleichgroße, in Längsrichtung verlaufende Kontaktstege unterteilt.

6. Stiftförmiges Kontaktelement nach einem der Ansprüche 1 bis 5, dadurch gekennzeichnet, daß die Rinne (9) einen kreissegmentförmigen Querschnitt aufweist.

7. Stiftförmiges Kontaktelement nach einem der Ansprüche 1 bis 6, dadurch gekennzeichnet, daß in der Nähe des Anschlußbereiches (5) an einen jeden der beiden Kontaktschenkel (7) eine Übergangszone angeformt ist, in der der Querschnitt der beiden Kontaktschenkel (7) wieder kontinuierlich zunehmend ausgebildet ist.

## Claims

1. Pin-shaped contact for the contacting connection to the plated-through holes of electric printed circuit boards, featuring a connection region and a press-in area allocated to the hole, whereby the connecting region, with its lower side facing the press-in area, corresponds with one of the main surfaces of the electric printed board, and whereby there is an elongated hole formed like a needle-eye within the press-in area, so that two resilient contact legs are formed which are movable towards each other and which are connected to each other as one piece at their free ends and the outer longitudinal sides of which face each other and come to rest on the wall of the hole, generating bearing forces, whereby the edge zones of the longitudinal sides of the two contact legs which run in a V shape at an acute angle to each other feature a distinctly rounded formation, **characterized by the fact that** the elongated hole (3) formed by the two contact legs (7) extends from its start at a slight distance from the free end (10) of the press-in area (4) to the lower side of the connecting region (5), whereby the contour of the elongated hole (3) and the bow-shaped course of the longitudinal sides of the two contact legs (7) are coordinated in such a way that the cross-section of each of the two contact legs (7) is shaped to continuously increase from approximately the beginning of the elongated hole (3) until the maximum width is reached and to continuously decrease from the maximum width until a transition zone to the lower side of the contacting region (5) is reached.

2. Pin-shaped contact in accordance with claim 1, characterized by the fact that in each of the two longitudinal sides of the two contact legs (7) at least one groove (9) is formed in the longitudinal direction.

3. Pin-shaped contact in accordance with claim 1 or 2, characterized by the fact that the groove (9) extends at least over the middle section of each of the two longitudinal sides which feature the greatest width of the contact legs (7).

4. Pin-shaped contact in accordance with claim 1 or 2, characterized by the fact that the groove (9) extends over the entire length of each of the two longitudinal sides.

5. Pin-shaped contact in accordance with one of claims 1 to 4, characterized by the fact that the groove (9) divides each of the two longitudinal sides into two contact segments of equal size running in the longitudinal direction.

6. Pin-shaped contact in accordance with one of claims 1 to 5, characterized by the fact that the groove (9) features a cross-section shaped like a segment of a circle.

7. Pin-shaped contact in accordance with one of claims 1 to 6, characterized by the fact that near the connecting region (5) a transition zone is formed onto each of the two contact legs (7) where the cross-section of the two contact legs (7) is formed to increase continuously.

## Revendications

1. Elément de contact en forme de pointe destiné à établir le contact par fixation dans les perforations métallisées de plaquettes de circuits électriques et présentant une zone de raccordement et une zone d'insertion sous contrainte affectée à la perforation, la zone de raccordement étant coordonnée, par sa surface inférieure, dirigée vers la zone d'insertion sous contrainte, à l'une des principales surfaces de la plaquette de circuits électriques et la zone d'insertion sous contrainte étant pourvue d'un trou oblong en forme de chas d'aiguille de sorte à former deux branches de contact déplaçables élastiquement, l'une vers l'autre, en faisant ressort, et reliées ensemble par leur extrémité libre, les côtés longitudinaux, extérieurs, détournés l'un de l'autre, de ces branches de contact venant porter contre la paroi de la perforation en exerçant des forces de pression contre celle-ci et les zones de chant des côtés longitudinaux de deux branches de contact, s'étendant l'un vers l'autre en forme de V en formant un angle aigu, présentant une forme nettement arrondie,
caractérisé en ce que
le trou oblong (3), donnant naissance aux deux branches de contact (7), partant à faible distance de l'extrémité libre (10) de la partie comprimable (4), s'étend jusque dans la surface inférieure de la partie de raccordement (5), le contour du trou oblong (3) et les contours arqués des côtés longitudinaux des deux branches de contact (7) étant mutuellement adaptés de sorte que la section transversale de chacune des deux branches de contact (7) augmente en continu, jusqu'à son maximum, à peu près à partir du début du trou oblong (3) pour décroître progressivement, à partir de ce point maximum, jusqu'à une zone de transition adjacente à la surface inférieure de la zone de raccordement (5).

2. Elément de contact selon la revendication 1,
caractérisé en ce que,
dans chacun des côtés longitudinaux des deux branches de contact (7), un canal (9), au moins, est prévu, lequel s'étend dans le sens de la longueur.

3. Elément de contact selon la revendication 1 ou 2,
caractérisé en ce que
le canal (9) s'étend au moins sur le secteur médian de chacun des deux côtés longitudinaux où les branches de contact (7) atteignent la plus grande extension.

4. Elément de contact selon la revendication 1 ou 2,
caractérisé en ce que
le canal (9) s'étend sur la longueur totale de chacun des deux côtés longitudinaux.

5. Elément de contact selon l'une des revendications 1 à 4,
caractérisé en ce que
le canal (9) divise chacun des deux côtés longitudinaux en deux barres de contact de mêmes dimensions et s'étendant dans le sens de la longueur.

6. Elément de contact selon l'une des revendications 1 à 5,
caractérisé en ce que
le canal (9) présente une section transversale en forme de segment de cercle.

7. Elément de contact selon l'une des revendications 1 à 6,
caractérisé en ce que,
dans chacun des deux branches de contact (7), une zone de transition est formée, la section transversale des deux branches de contact (7) augmentant de nouveau progressivement dans cette zone de transition.
